# FASCICULE DE BREVET EUROPEEN

(11) **EP 2 974 578 B1**
(45) Date de publication et mention de la délivrance du brevet: **19.09.2018**
(21) Numéro de dépôt: 14713549.5
(22) Date de dépôt: 12.03.2014
(51) Int. Cl.: H05K 9/00, B60K 1/04, B60R 16/04, H01M 2/10

(54) **CAISSON D'HÉBERGEMENT D'ÉQUIPEMENT DE PUISSANCE DE VÉHICULE AUTOMOBILE FORMANT BLINDAGE ÉLECTROMAGNÉTIQUE**
KRAFTFAHRZEUGANTRIEBSANLAGE MIT EINEM KASTENABSCHNITTSGEHÄUSE ZUR FORMUNG EINER ELEKTROMAGNETISCHEN ABSCHIRMUNG
BOX SECTION HOUSING MOTOR VEHICLE POWER EQUIPMENT FORMING ELECTROMAGNETIC SCREENING

(30) Priorité: 12.03.2013 FR 1352200
(43) Date de publication de la demande: 20.01.2016
(73) Titulaire: Compagnie Plastic Omnium, 69007 Lyon (FR)
(72) Inventeur: ANDRE, Gérald, 01500 Amberieu En Bugey (FR)
(74) Mandataire: Remy, Vincent Noel Paul
(86) Numéro de dépôt international: PCT/FR2014/050550
(87) Numéro de publication internationale: WO 2014/140472

(56) Documents cités:
- EP-A1- 2 427 038
- WO-A1-2012/042964
- DE-A1-102011 052 515
- JP-A- 2012 084 450
- US-A1- 2010 300 744
- US-B1- 7 063 767

## Description

La présente invention concerne l'hébergement de batteries d'entrainement de véhicules automobiles électriques ou hybrides et/ou de composants électriques de véhicules automobiles électriques ou hybrides transmettant des puissances électriques d'entrainement de tels véhicules.

Pour encapsuler un ensemble de batteries dans un véhicule électrique ou hybride, la solution actuelle consiste à réaliser un caisson entièrement en métal, notamment en aluminium afin d'empêcher les batteries d'émettre des rayonnements électromagnétiques à l'extérieur du caisson vers les passagers ou vers de l'électronique du véhicule. Le choix de ce métal est justifié par sa tenue mécanique et sa conductivité. En effet, un blindage électromagnétique s'avère nécessaire autour de l'espace d'hébergement pour confiner les champs importants générés par les batteries et/ou les autres composants électriques de puissance liés à l'entrainement du véhicule. Or la forte conductivité de l'aluminium lui confère une bonne aptitude pour un tel blindage électromagnétique.

Néanmoins une telle solution reste insatisfaisante en termes de compromis entre coût de réalisation et efficacité de blindage. En effet, la grande quantité d'aluminium utilisée pour la réalisation de ces caissons les rend lourds et particulièrement onéreux. Ces caissons sont en outre complexes à réaliser dans un processus de production industrielle de masse. De plus, un tel caisson est d'une efficacité ordinaire en ce qui concerne l'arrêt des rayonnements électromagnétiques spécifiquement dus aux batteries et aux composants électriques de puissance accompagnant les batteries pour l'acheminement de l'énergie d'entrainement du véhicule.

JP 2012 084450 A divulgue un caisson d'hébergement d'équipement embarqué de stockage de véhicule automobile, le caisson décrivant une surface enfermant complètement un logement de réception d'un tel équipement, le caisson comprenant une couche conductrice de base appliquée sur la paroi intérieure et une couche conductrice additionnelle appliquée sur la paroi extérieure.

US 2010/300744 A1 divulgue un écran électromagnétique comprenant une couche conductrice de base, constituée d'au moins un matériau conducteur, s'étendant sur l'ensemble de ladite surface décrite par le caisson, le caisson comprend en outre une couche conductrice additionnelle constituée d'au moins un matériau conducteur distinct du matériau conducteur de la couche conductrice de base, recouvrant au moins partiellement ladite couche conductrice de base, la couche conductrice de base et la couche conductrice additionnelle étant réalisées par pulvérisation de leurs matériaux constitutifs.

US 7 063 767 B1 divulgue un caisson d'hébergement selon le préambule de la revendication 1.

Le but de l'invention est de proposer un caisson de véhicule automobile pour l'hébergement de batteries et/ou de composants électriques transmettant une puissance électrique d'entrainement du véhicule lequel caisson soit robuste, léger, d'un coût suffisamment faible pour une réalisation en grande série, et ait une efficacité de blindage suffisante pour empêcher les batteries et/ou les composants électriques d'émettre des rayonnements électromagnétiques à l'extérieur du caisson vers les passagers ou vers de l'électronique du véhicule.

Ce but est atteint selon l'invention grâce à un caisson selon la revendication 1.

Avantageusement, le caisson comprend une couche en matériau électriquement isolant interposée entre la couche conductrice de base et la couche conductrice additionnelle.

Avantageusement, la couche conductrice de base est constituée d'au moins un matériau de blindage électromagnétique.

Avantageusement, la couche conductrice de base est constituée d'au moins un matériau présentant une conductivité supérieure à 1.10⁷ S/m.

Avantageusement, la couche conductrice de base comporte au moins une partie constituée d'aluminium.

Avantageusement, la couche conductrice additionnelle est constituée d'un matériau de blindage de type électromagnétique.

Avantageusement, ledit matériau de blindage de type électromagnétique constituant la couche conductrice additionnelle présente une conductivité supérieure à 1.10⁷ S/m.

Avantageusement, la couche conductrice additionnelle est constituée d'un matériau de blindage de type magnétique.

Avantageusement, le matériau de blindage de type magnétique présente une perméabilité magnétique relative ayant une valeur supérieure à 100.

Avantageusement, le matériau de blindage de type magnétique fait partie du groupe constitué du nickel, du fer, du permalloy, de l'acier et des mu-métaux.

Avantageusement, le matériau de blindage de type magnétique fait partie du groupe constitué du fer et de l'acier.

Avantageusement, la couche conductrice additionnelle présente une épaisseur comprise entre 0,05 mm et 0,1 mm.

Avantageusement, le caisson comprend une coque en matière plastique ou en matériau composite à matrice en matière plastique, la couche conductrice de base et la couche conductrice additionnelle recouvrant au moins partiellement ladite coque.

Avantageusement, la coque ayant un côté intérieur et un côté extérieur en référence à une forme générale du caisson, la couche conductrice de base et la couche conductrice additionnelle sont disposées d'un même côté de la coque parmi ces deux côtés.

Avantageusement, la coque ayant un côté intérieur et un côté extérieur en référence à une forme générale du caisson, la couche conductrice de base (30) et la couche conductrice additionnelle sont disposées chacune sur un côté différent de la coque parmi ces deux côtés.

Avantageusement, au moins une des couches parmi la couche conductrice de base (30) et la couche conductrice additionnelle est réalisée par fourniture d'une feuille de son ou ses matériau(x) constitutif(s) et placement de cette feuille en recouvrement de la dite coque (10,100).

Avantageusement, au moins une des couches parmi la couche conductrice de base (30) et la couche conductrice additionnelle est réalisée par pulvérisation de son ou ses matériau(x) constitutif(s).

L'invention concerne également une utilisation en tant que caisson selon la revendication 18.

La matière plastique peut être thermoplastique ou thermodurcissable.

L'invention sera mieux comprise à la lecture de la description qui va suivre, donnée uniquement à titre d'exemple et faite en se référant aux dessins dans lesquels :
- la figure 1 est une vue en coupe transversale d'une paroi de caisson selon un mode de réalisation de l'invention ;
- la figure 2 est une vue éclatée et en perspective d'un caisson selon ce même mode de réalisation de l'invention.

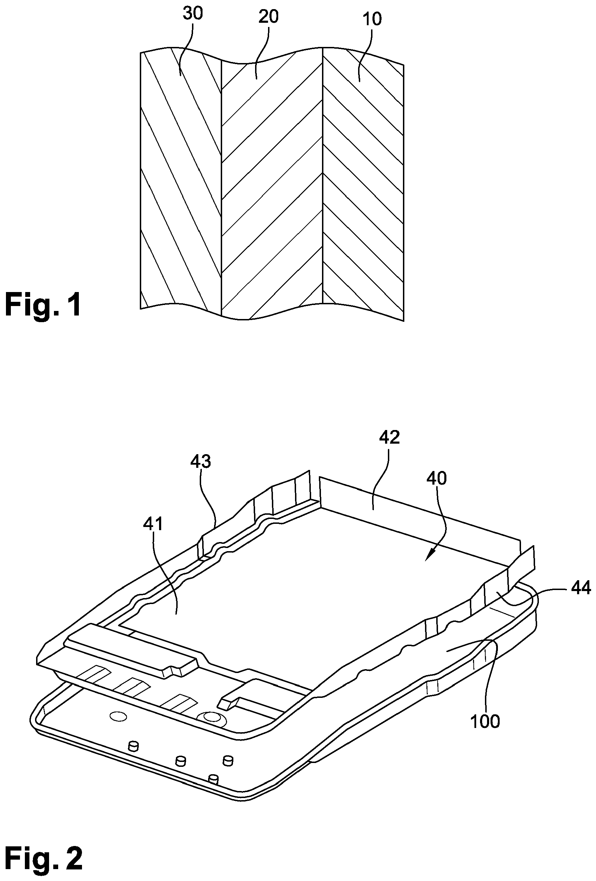

Tel que représenté sur la figure 1, un caisson décrit maintenant présente une paroi à trois couches. Une première couche 10 est une couche de support en matière plastique ou organique, telle qu'un polymère moulé en forme de demi-coque. Une telle matière plastique est par exemple thermoplastique ou thermodurcissable. La couche de support peut en variante être une couche en matériau composite dont la matrice est en matière plastique, que cette matière plastique soit thermoplastique ou thermodurcissable. Une deuxième couche 20 est dans le présent exemple une couche conductrice ayant des propriétés de blindage magnétique, ici une couche de fer. Une troisième couche 30 appelée par la suite couche conductrice de base, est ici une couche de blindage électromagnétique, ici une couche d'aluminium.

Le présent caisson entoure un espace de réception pour un équipement de puissance du véhicule en décrivant une surface qui enferme totalement un tel espace de réception de l'équipement. La couche conductrice de base 30 s'étend sur l'ensemble d'une telle surface de telle sorte qu'elle ne laisse aucun passage libre pour des ondes émises par l'équipement de puissance vers l'extérieur du caisson.

Le blindage électromagnétique est connu en soi. Il fait généralement appel à une couche métallique fortement conductrice, telle qu'une couche en aluminium ou en cuivre. Les propriétés conductrices de la couche de cuivre ou d'aluminium ont pour effet d'annuler la composante électrique du champ électromagnétique, empêchant alors ce dernier de traverser le blindage ainsi formé.

Plus spécifiquement, on privilégie ici un matériau de blindage électromagnétique ayant une forte conductivité, typiquement supérieure à 1.10⁷ S/m. De tels matériaux de blindage électromagnétique sont, outre l'aluminium ou le cuivre, par exemple le zinc. Ainsi, l'Aluminium présente une conductivité de 3,5.10⁷ S/m, le cuivre présente une conductivité de 5.96×10⁷ S/m, le zinc présente une conductivité de 16,9.10⁶ S/m. Ces métaux sont donnés ici à titre d'exemple et selon des variantes de réalisation on adopte des alliages de ces différents métaux ou des matériaux composites comprenant une matrice par exemple en matière plastique dans laquelle sont noyées des particules de tels matériaux pour leur aptitude à former une barrière électromagnétique.

Dans le présent exemple on utilise pour la couche 20, également appelée couche conductrice additionnelle dans la suite, un matériau de blindage magnétique. L'efficacité du blindage magnétique dépend de la perméabilité magnétique du matériau, ou de sa valeur de perméabilité magnétique relative qui est le ratio de la valeur de la perméabilité magnétique du matériau considéré sur la valeur de la perméabilité magnétique du vide. Cette efficacité s'évanouit pour les fortes valeurs de champ magnétique du fait que le matériau entre alors en saturation.

Dans le présent exemple, le matériau de blindage magnétique constituant la couche 20 est constitué principalement de fer, le fer présentant une perméabilité magnétique relative de 5000. La couche 20 est ici une couche d'acier commun lequel présente une valeur de perméabilité magnétique relative de 100. En variante, la couche 20 est réalisée en nickel. Le nickel présente une perméabilité magnétique relative comprise entre 100 et 600, selon les caractéristiques du champ magnétique rencontré.

En variante, on utilise un mu-matériau ou un mu-métal, également noté µ-métal. Un mu-métal est un alliage de nickel et de fer. Le mu-métal, qui présente une perméabilité magnétique extrêmement élevée, est particulièrement adapté à cet usage. Il existe plusieurs nuances de mu-métal en fonction du fabricant. Un mu-métal de type « français » est typiquement composé à 80 % de nickel, à 15 % de fer, et à 5 % de molybdène. Sa désignation symbolique selon la norme européenne est NiFe15Mo5. Un mu-métal de type « allemand » est composé à 77 % de nickel, à 15 % de fer, à 5 % de cuivre et à 3 % de molybdène. Sa désignation symbolique selon la norme européenne est NiFe15Cu5Mo3. Les Mu-métaux présentent une perméabilité magnétique relative comprise entre 20 000 et 50 000. Le permalloy, marque déposée, ou le supermalloy, marque déposée, qui sont également des alliages composés principalement de fer et de nickel, peuvent aussi être utilisés. Le permalloy présente une perméabilité magnétique relative de 8000.

Ces différents matériaux, et plus généralement les matériaux ayant une valeur de perméabilité magnétique relative qui soit supérieure à 100, permettent de produire un effet de blindage d'ensemble surprenant à basse fréquence. Pour une efficacité encore accrue, on privilégie un matériau ayant une valeur de perméabilité magnétique relative qui soit supérieure à 1000.

Cet effet de blindage électromagnétique est particulièrement élevé lorsque la couche conductrice de base 30 est placée du côté des batteries ou des équipements électriques de puissance par rapport à la couche de blindage magnétique 20, donc vers l'intérieur du caisson par rapport à la couche de blindage magnétique 20. Dans le présent exemple, la couche conductrice 30 d'aluminium constitue une couche apparente à l'intérieur du caisson. Cette disposition présente en outre l'avantage de protéger la couche de blindage magnétique 20 laquelle est ici principalement en fer de la corrosion qui pourrait être provoquée par une certaine humidité dans le caisson ou par la présence d'acides émanant des batteries.

Dans un autre exemple de réalisation décrit maintenant, la couche 20 est une couche réalisée en un matériau n'ayant pas de propriétés de blindage magnétique en tant que telle. Ainsi dans l'exemple décrit maintenant, le matériau constitutif de la couche 20 est un aluminium, la couche conductrice de base 30 étant, elle, réalisée en zinc dans cet exemple.

Il apparait que la superposition de telles couches électriquement conductrices 20 et 30 permet d'obtenir un effet de blindage électromagnétique du caisson d'une efficacité surprenante, surpassant très nettement la somme théorique des deux effets de chacune des couches 20 et 30 considérées séparément.

Ainsi, on peut réaliser le caisson en y ménageant une superposition de deux couches électriquement conductrices et y obtenir un effet de blindage électromagnétique déjà surprenant et ce pour un coût faible lorsque les matériaux utilisés sont de matériaux à faible coût comme ici l'aluminium et le zinc.

Selon différentes variantes, de tels matériaux peuvent même être conducteurs sans toutefois être des matériaux à propriétés de blindage électromagnétique en tant que tels. En variante encore, le matériau d'une seule des couches peut être un matériau ayant des propriétés de blindage électromagnétique, et en variante encore les deux matériaux peuvent être des matériaux de blindage électromagnétique. En variante encore, une couche de matériau de blindage magnétique est placée entre deux couches conductrices, ces deux couches présentant éventuellement des propriétés de blindage électromagnétique lorsque considérées individuellement. Une telle couche de blindage magnétique peut également être placée entre deux couches d'isolant et deux couches conductrices.

Selon un mode de réalisation, la couche conductrice de base 30, bien que s'étendant sur l'ensemble de la surface du caisson pour enfermer totalement l'espace de réception de l'équipement, peut être constituée de plusieurs matériaux venant en jonction l'un de l'autre. Ainsi, la couche conductrice de base 30 peut être constituée d'un feuille d'acier pour une partie du caisson de manière à produire un effet de tenue structurelle du caisson dans cette partie, et être complétée pour une partie réalisée sous la forme d'une peinture conductrice ou sous la forme d'un matériau conducteur déposé par projection. Un tel mode de réalisation est adéquat lorsque, dans la partie complémentaire ainsi réalisée, la couche conductrice de base 30 n'a pas à produire d'effet de renforcement mécanique de protection de surface.

Les batteries et leurs équipements associés dégagent ici un rayonnement électromagnétique dont la fréquence est de l'ordre de 100 Hz à 1 MHz. Ainsi on procède dans les exemples décrits ici à une superposition d'une couche conductrice de base 30 et d'une couche conductrice additionnelle 20, cette superposition apportant un surcroit d'efficacité surprenant dans cette gamme de basses fréquences de champs électromagnétiques et pour les amplitudes de champs électromagnétiques en présence. Plus généralement, pour encapsuler de telles batteries de véhicules, où les champs électromagnétiques sont à basses fréquences, il apparait qu'une telle superposition produit un effet de blocage électromagnétique surprenant.

On obtient ainsi un effet que l'on peut qualifier d'effet multicouche, encore accru lorsqu'une couche isolante est utilisée en interposition, lequel effet semble fonctionner par plusieurs types d'atténuation. Un premier effet semble se produire au niveau d'une couche conductrice considérée. Une part du rayonnement électromagnétique est transmise vers la couche extérieure suivante tandis qu'une part du rayonnement est réfléchie, revenant vers l'intérieur du caisson. Entre deux couches conductrices, il se produit un phénomène de piégeage et de rebonds des ondes, et ce d'autant mieux si les deux couches conductrices sont séparées par une couche isolante. Il se produit également un auto-amortissement des ondes piégées d'une part, mais aussi entre celles émises ou réfléchies, par une sorte de déphasage généré lors de la traversée ou rebond au niveau des interfaces.

L'effet surprenant dû à la superposition de telles couches conductrices 20 et 30 est encore accru lorsque ces couches sont séparées par une couche d'interposition non conductrice. Ainsi, selon un mode de réalisation avantageux, on place la couche conductrice de base 30 et la couche conductrice additionnelle 20 de part et d'autre de la couche 10 formant la coque plastique, la coque plastique formant alors le matériau d'interposition ou entrefer. Bien que les épaisseurs illustrée à la figure 1 ne soient pas représentatives des épaisseurs réelles, une telle coque présente ici une épaisseur de 3 mm qui est épaisseur particulièrement adéquate en termes d'accroissement d'efficacité dû à la couche d'interposition. De manière plus générale, la couche isolante intermédiaire présente avantageusement une épaisseur comprise entre 0,1 et 4,0 mm. Dans un tel mode de réalisation, on recouvre avantageusement une couche lorsqu'elle est en fer d'une couche de vernis pour protéger cette dernière des rayures et de la corrosion ou encore d'agressions chimiques comme par exemple d'oxydo-réduction.

Selon une variante, les couches 20 et 30 sont placées d'un même côté de la coque plastique, les couches 20 et 30 étant séparées entre elles par un matériau isolant qui est idéalement un matériau plastique, que ce matériau plastique soit un matériau thermoplastique ou un matériau thermodurcissable. L'épaisseur d'une telle couche est avantageusement inférieure à 2 mm, idéalement inférieure à 0,1 mm. Une telle couche d'isolant est par exemple un vernis tel qu'un vernis thermodurcissable ou encore un film isolant. Un tel mode de réalisation présente l'intérêt d'être plus facilement mis en oeuvre industriellement. Dans un mode de réalisation, le fait de disposer une couche d'aluminium en protection d'une couche de fer constitue une protection de la couche de fer contre la corrosion qui est plus efficace qu'une couche de vernis seule. Cependant une couche de vernis est avantageusement déposée sur la ou les couches de métal apparente(s), que la couche de métal soit orientée vers l'intérieur ou vers l'extérieur du caisson, afin de protéger une telle couche à la fois d'éventuelles rayures et également vis-à-vis de la corrosion.

Lorsque les couches 20 et 30 sont disposées du côté interne du caisson, il existe un risque de contact électrique entre les couches conductrices et les systèmes de puissance qui sont placés dans le caisson en cas d'accident du véhicule par exemple. Néanmoins les couches 20 et 30 sont mieux protégées de ce côté de la paroi plastique car elles ne sont pas soumises à des agressions mécaniques au montage des systèmes de puissance ou lors des opérations de maintenance de ces systèmes. Les couches 20 et 30 sont en outre protégées des agressions environnementales telles que l'humidité laquelle génère de la corrosion. Il est en effet à noter que les effets de blindage produits par ces matériaux peuvent se dégradent sous l'effet de la corrosion.

Lorsque les couches 20 et 30 sont disposés du côté externe du caisson, il y a moins de risque de contact électrique avec les systèmes situés à l'intérieur en cas de choc du véhicule. Néanmoins le fait de disposer au moins une couche à l'extérieur peut imposer de finir ou d'ajouter une couche isolante ou un vernis pour protéger la dernière couche métallique de la corrosion ou des griffures.

Pour une efficacité optimale, les épaisseurs des couches 20 et 30 sont ici les suivantes. La couche 20 présente avantageusement une épaisseur comprise entre 0,05 mm et 0,1 mm. La couche conductrice de base 30 présente avantageusement une épaisseur comprise entre 0,01 mm et 0,2 mm, préférentiellement entre 0,05 et 0,2 mm pour un optimum d'effet de blindage d'ensemble et de coût du caisson final. Lorsque la couche 20 est une couche de mu-matériau, son épaisseur peut descendre jusqu'à 0,01 mm par exemple.

Les couches conductrices 20 et 30 sont ici fournies sous formes de feuilles en rouleaux. Les feuilles sont déroulées, puis laminées entre elles. Avantageusement une couche de vernis est disposée entre les deux couches avant laminage, laquelle couche de vernis et plus généralement la couche d'isolant remplit également une fonction de collage des couches 20 et 30 entre elles.

Tel que représenté sur la figure 2, l'ensemble ainsi laminé est ensuite mis en forme par pliage et étirage ou emboutissage selon une forme en demi coque 40 identique à une demi-coque 100 en matière plastique telle qu'un polymère ici. L'ensemble 40 formé des deux couches 20 et 30 ainsi mises en forme présente ici une portion centrale sensiblement plate 41, bordée à son extrémité par un redressement 42 et bordée latéralement par deux ailes 43 et 44. Ces deux ailes 43 et 44 s'étendent ici depuis une extrémité de l'ensemble 40 qui est opposée à l'extrémité formant le redressement 42, ces deux ailes 43 et 44 s'étendant depuis cette extrémité opposée pour venir rejoindre le redressement 41. Cet ensemble 40 est ensuite placé à l'intérieur de la demi-coque 100 en étant collé contre la face interne de la demi-coque 100, la demi-coque se trouvant alors complètement recouverte intérieurement. Une demi-coque opposée est équipée de la même façon d'un ensemble constitué de deux couches 20 et 30 également laminées entre elles. Les demi-coques sont ensuite assemblées entre elles pour former le caisson. Un tel caisson, outre son efficacité en termes de blindage électromagnétique, présente une légèreté ainsi qu'une résistance mécanique, une capacité d'isolation thermique, et une étanchéité qui le rendent adapté pour l'hébergement de batteries ou d'équipements électriques de puissance dans un véhicule. Le caisson décrit ici est mieux adapté pour adopter des formes spécifiques à son environnement dans un espace disponible réduit dans le véhicule et plus adapté pour pouvoir y intégrer, par exemple par moulage, des fonctionnalités comme par exemple des interfaces de fixation sur caisse. En variante, l'ensemble 40 une fois mis en forme peut être surmoulé d'une matière plastique pour former la demi-coque 100 sur l'ensemble 40 lui-même. Selon une disposition avantageuse, l'ensemble 40 formé des couches 20 et 30 peut être travaillé sous forme de microstructures facilitant les élongations de cet ensemble 40 lors de sa mise en forme.

Selon une variante, les couches 20 et 30 sont réalisées par projection de leur matériau constitutif. Ainsi, en variante la couche 20 est réalisée par projection sur la demi-coque 100 de fer à l'état de poudre grâce à un procédé connu sous la locution anglo-américaine de « Arc-spray », ou encore être projetée sous forme de métal en fusion, directement sur une demi-coque en matériau composite, éventuellement munie d'un vernis. La couche 30 peut également être projetée sur la couche 20 selon le même procédé, ou encore être projetée sous forme par exemple d'aluminium fondu. Une réalisation d'une couche d'aluminium par projection de poudre ou d'aluminium fondu permet avantageusement de réaliser une telle couche 30 en aluminium laquelle présente une certaine rugosité de surface, laquelle rugosité produit un effet bénéfique de déviation des lignes de champ électromagnétique. On obtient alors une efficacité encore accrue du blindage électromagnétique produit par l'ensemble des deux couches 20 et 30.

Un caisson réalisé selon les exemples décrits ici empêche non seulement le rayonnement de sortir du caisson mais également il empêche un rayonnement extérieur de venir perturber l'équipement logé dans le caisson.

## Revendications

1. Caisson d'hébergement d'équipement embarqué de stockage et/ou de transmission de puissance électrique d'entrainement de véhicule automobile, le caisson décrivant une surface enfermant complètement un logement de réception d'un tel équipement, le caisson comprenant une couche conductrice de base (30), constituée d'au moins un matériau conducteur, s'étendant sur l'ensemble de ladite surface décrite par le caisson, le caisson comprend en outre une couche conductrice additionnelle (20) constituée d'au moins un matériau conducteur distinct du matériau conducteur de la couche conductrice de base, recouvrant au moins partiellement ladite couche conductrice de base (30), la couche conductrice de base (30) et la couche conductrice additionnelle (20) étant réalisées par pulvérisation de leurs matériaux constitutifs, le caisson étant **caractérisé en ce que** la couche conductrice de base (30) présente une épaisseur comprise entre 0,05 mm et 0,5 mm.

2. Caisson d'hébergement selon la revendication 1, **caractérisé en ce qu'**il comprend une couche en matériau électriquement isolant interposée entre la couche conductrice de base (30) et la couche conductrice additionnelle (20).

3. Caisson d'hébergement selon la revendication 1 ou la revendication 2, **caractérisé en ce que** la couche conductrice de base (30) est constituée d'au moins un matériau de blindage électromagnétique.

4. Caisson d'hébergement selon l'une quelconque des revendications précédentes, **caractérisé en ce que** la couche conductrice de base (30) est constituée d'au moins un matériau présentant une conductivité supérieure à 1.10⁷ S/m.

5. Caisson d'hébergement selon l'une quelconque des revendications précédentes, **caractérisé en ce que** la couche conductrice de base (30) comporte au moins une partie constituée d'aluminium.

6. Caisson d'hébergement selon l'une quelconque des revendications précédentes, **caractérisé en ce que** la couche conductrice additionnelle (20) est constituée d'un matériau de blindage de type électromagnétique.

7. Caisson selon la revendication précédente, **caractérisé en ce que** ledit matériau de blindage de type électromagnétique constituant la couche conductrice additionnelle (20) présente une conductivité supérieure à 1.10⁷ S/m.

8. Caisson selon l'une quelconque des revendications 1 à 5, **caractérisé en ce que** la couche conductrice additionnelle (20) est constituée d'un matériau de blindage de type magnétique.

9. Caisson d'hébergement selon la revendication précédente, **caractérisé en ce que** le matériau de blindage de type magnétique présente une perméabilité magnétique relative ayant une valeur supérieure à 100.

10. Caisson d'hébergement selon la revendication précédente, **caractérisé en ce que** le matériau de blindage de type magnétique présente une perméabilité magnétique relative ayant une valeur supérieure à 1000.

11. Caisson d'hébergement selon la revendication 8 ou la revendication 9, **caractérisé en ce que** le matériau de blindage de type magnétique fait partie du groupe constitué du nickel, du fer, du permalloy, de l'acier et des mu-métaux.

12. Caisson d'hébergement selon la revendication 8 ou la revendication 9, **caractérisé en ce que** le matériau de blindage de type magnétique fait partie du groupe constitué du fer et de l'acier.

13. Caisson d'hébergement selon l'une quelconque des revendications précédentes, **caractérisé en ce que** la couche conductrice additionnelle (20) présente une épaisseur comprise entre 0,05 mm et 0,1 mm.

14. Caisson d'hébergement selon l'une quelconque des revendications précédentes, **caractérisé en ce qu'**il comprend une coque (10, 100) en matière plastique ou en matériau composite à matrice en matière plastique, la couche conductrice de base (30) et la couche conductrice additionnelle (20) recouvrant au moins partiellement ladite coque (10,100).

15. Caisson d'hébergement selon la revendication précédente, **caractérisé en ce que** la coque (10,100) ayant un côté intérieur et un côté extérieur en référence à une forme générale du caisson, la couche conductrice de base (30) et la couche conductrice additionnelle (20) sont disposées d'un même côté de la coque (10,100) parmi ces deux côtés.

16. Caisson d'hébergement selon la revendication 14, **caractérisé en ce que** la coque (10,100) ayant un côté intérieur et un côté extérieur en référence à une forme générale du caisson, la couche conductrice de base (30) et la couche conductrice additionnelle (20) sont disposées chacune sur un côté différent de la coque (10,100) parmi ces deux côtés.

17. Caisson d'hébergement selon l'une quelconque des revendications 14 à 16, **caractérisé en ce qu'**au moins une des couches parmi la couche conductrice de base (30) et la couche conductrice additionnelle (20) est réalisée par fourniture d'une feuille de son ou ses matériau(x) constitutif(s) et placement de cette feuille en recouvrement de la dite coque (10,100).

18. Utilisation en tant que caisson d'hébergement d'équipement embarqué de stockage et/ou de transmission de puissance électrique d'entrainement de véhicule automobile d'un caisson décrivant une surface enfermant complètement un logement de réception d'équipement, le caisson comprenant une couche conductrice de base (30), constituée d'au moins un matériau conducteur, s'étendant sur l'ensemble de la surface décrite par le caisson, le caisson comprenant en outre une couche conductrice additionnelle (20) constituée d'au moins un matériau conducteur distinct du matériau conducteur de la couche conductrice de base (30), recouvrant au moins partiellement ladite couche conductrice de base (30), la couche conductrice de base (30) et la couche conductrice additionnelle (20) étant réalisées par pulvérisation de leurs matériaux constitutifs, la couche conductrice de base (30) présentant une épaisseur comprise entre 0,05 mm et 0,5 mm.

## Patentansprüche

1. Kasten zur Unterbringung von Bordausrüstung zur Speicherung und / oder zur Übertragung elektrischer Leistung zum Antrieb eines Kraftfahrzeugs, wobei der Kasten eine Oberfläche beschreibt, die einen Platz zur Aufnahme einer solchen Ausrüstung vollständig umschließt, wobei der Kasten eine leitfähige Basisschicht (30) umfasst, bestehend aus mindestens einem leitfähigen Material, das sich über die gesamte von des Kastens beschriebene Oberfläche erstreckt, und der Kasten eine zusätzliche leitfähige Schicht (20) aus mindestens einem zu dem leitfähigen Material der Basisschicht (30) verschiedenen leitfähigen Material hergestellt ist, und die leitfähige Basisschicht (30) zumindest teilweise abdeckt, wobei die leitende Basisschicht (30) und die zusätzliche leitfähige Schicht (20) durch Aufsprühen ihres Grundmaterials hergestellt sind, und wobei das Gehäuse **dadurch gekennzeichnet ist, dass** die leitende Basisschicht (30) eine Dicke zwischen 0,05 mm und 0,5 mm aufweist.

2. Kasten nach Anspruch 1, **dadurch gekennzeichnet, dass** er eine Schicht aus elektrisch isolierendem Material aufweist, die zwischen der leitenden Basisschicht (30) und der zusätzlichen leitenden Schicht (20) angeordnet ist.

3. Kasten nach Anspruch 1 oder 2, **dadurch gekennzeichnet, dass** die leitfähige Basisschicht (30) aus mindestens einem elektromagnetischen Abschirmmaterial besteht.

4. Kasten nach einem der vorhergehenden Ansprüche, **dadurch gekennzeichnet, dass** die leitfähige Basisschicht (30) aus mindestens einem Material mit einer Leitfähigkeit größer als 1 x 10⁷ S/m besteht.

5. Kasten nach einem der vorhergehenden Ansprüche, **dadurch gekennzeichnet, dass** die leitfähige Basisschicht (30) mindestens einen Teil aus Aluminium umfasst.

6. Kasten nach einem der vorhergehenden Ansprüche, **dadurch gekennzeichnet, dass** die zusätzliche leitfähige Schicht (20) aus einem Abschirmmaterial elektromagnetischer Art besteht.

7. Kasten nach dem vorhergehenden Anspruch, **dadurch gekennzeichnet, dass** das Abschirmmaterial elektromagnetischer Art, das die zusätzliche leitende Schicht (20) bildet, eine Leitfähigkeit von mehr als 1 × 10⁷ S / m aufweist.

8. Kasten nach einem der Ansprüche 1 bis 5, **dadurch gekennzeichnet, dass** die zusätzliche leitende Schicht (20) aus einem Abschirmmaterial magnetischer Art besteht.

9. Kasten nach dem vorhergehenden Anspruch, **dadurch gekennzeichnet, dass** das Abschirmmaterial magnetischer Art (20) eine relative magnetische Permeabilität mit einem Wert größer als 100 aufweist.

10. Gehäuse nach dem vorhergehenden Anspruch, **dadurch gekennzeichnet, dass** das Abschirmmaterial magnetischer Art (20) eine relative magnetische Permeabilität mit einem Wert größer als 1000 aufweist.

11. Kasten nach Anspruch 8 oder 9, **dadurch gekennzeichnet, dass** das magnetische Abschirmmaterial (20) Teil der Gruppe ist, die aus Nickel, Eisen, Permalloy, Stahl und Mu-Metallen besteht.

12. Kasten nach Anspruch 8 oder 9, **dadurch gekennzeichnet, dass** das Abschirmmaterial (20) vom magnetischen Typ Teil der Gruppe ist, die aus Eisen und Stahl besteht.

13. Kasten nach einem der vorhergehenden Ansprüche, **dadurch gekennzeichnet, dass** die zusätzliche leitfähige Schicht (20) eine Dicke zwischen 0,05 mm und 0,1 mm aufweist.

14. Kasten nach einem der vorhergehenden Ansprüche, **dadurch gekennzeichnet, dass** sie eine Hülle (10,100) aus Kunststoff oder aus einem Kunststoffmatrix-Verbundmaterial umfasst, wobei die leitfähige Basisschicht (30) und die zusätzliche leitfähige Schicht (20) die Hülle (10, 100) zumindest teilweise bedecken.

15. Kasten nach dem vorhergehenden Anspruch, **dadurch gekennzeichnet, dass** die Hülle (10, 100) eine Innenseite und eine Außenseite bezüglich einer allgemeinen Form des Kastens aufweist, wobei die leitende Basisschicht (30) und die zusätzliche leitende Schicht auf jeweils einer gleichen Seite der Hülle (10, 100) dieser beiden Seiten angeordnet sind.

16. Kasten nach dem vorhergehenden Anspruch, **dadurch gekennzeichnet, dass** die Hülle (10,100) eine Innenseite und eine Außenseite bezüglich einer allgemeinen Form des Kastens aufweist, wobei die leitende Basisschicht (30) und die zusätzliche leitende Schicht (20) auf jeweils einer unterschiedlichen Seite dieser beiden Seiten (10, 100) angeordnet sind.

17. Kasten nach einem der Ansprüche 14 bis 16, **dadurch gekennzeichnet, dass** mindestens eine der leitfähigen Basisschicht (30) und der zusätzlichen leitfähigen Schicht (20) durch Bereitstellen einer Folie aus ihrem / ihren Grundmaterial(ien) und durch Platzieren dieser Folie derart, dass sie die Hülle (10,100) abdeckt, hergestellt ist.

18. Verwendung eines Kastens zur Unterbringung von Bordausrüstung zur Speicherung und / oder zur Übertragung elektrischer Leistung zum Antrieb eines Kraftfahrzeugs, wobei der Kasten eine leitfähige Basisschicht (30) umfasst, die aus einem leitfähigen Material besteht, die sich über die gesamte von des Kastens beschriebenen Oberfläche erstreckt, und ferner der Kasten eine zusätzliche leitfähige Schicht (20) aufweist, die aus einem zu dem leitfähigen Material der Basisschicht (30) verschiedenen leitfähigen Material hergestellt ist, das mindestens teilweise die leitfähige Basisschicht (30) abdeckt, wobei die leitfähige Basisschicht (30) und die zusätzliche leitfähige Schicht (20) durch Aufsprühen ihrer Grundmaterialien hergestellt sind, und die leitende Basisschicht (30) eine Dicke zwischen 0,05 mm und 0,5 mm aufweist.

## Claims

1. Housing box motor vehicle drive electric power transmission and/or storage on-board equipment, the box section describing a surface completely enclosing a housing for receiving such equipment, the box section comprising a conducting base layer (30) made of at least one conducting material, extending entirely over said surface described by the box section, the box section further comprising an additional conducting layer (20) made of at least one conducting material different from the conducting material of the conducting base layer, at least partially covering said conducting base layer (30), the conducting base layer (30) and the additional conducting layer (20) being made by spraying their component materials, the box section being **characterised in that** the conducting base layer (30) has a thickness between 0.05 mm and 0.5 mm.

2. Housing box according to claim 1, **characterised in that** it comprises a layer of electrically insulating material interposed between the conducting base layer (30) and the additional conducting layer (20).

3. Housing box according to claim 1 or claim 2, **characterised in that** the conducting base layer (30) is made of at least one electromagnetic screening material.

4. Housing box according to any one of the preceding claims, **characterised in that** the conducting base layer (30) is made of at least one material having a conductivity greater than 1.10⁷ S/m.

5. Housing box according to any one of the preceding claims, **characterised in that** the conducting base layer (30) comprises at least one part made of aluminium.

6. Housing box according to any one of the preceding claims, **characterised in that** the additional conducting layer (20) is made of an electromagnetic type screening material.

7. Box section according to the preceding claim, **characterised in that** said electromagnetic type screening material forming the additional conducting layer (20) has a conductivity greater than 1.10⁷ S/m.

8. Box section according to any one of claims 1 to 5, **characterised in that** the additional conducting layer (20) is made of a magnetic type screening material.

9. Housing box according to the preceding claim, **characterised in that** the magnetic type screening material has a relative magnetic permeability greater than 100.

10. Housing box according to the preceding claim, **characterised in that** the magnetic type screening material has a relative magnetic permeability greater than 1000.

11. Housing box according to claim 8 or claim 9, **characterised in that** the magnetic type screening material is part of the group consisting of nickel, iron, permalloy, steel and mu-metals.

12. Housing box according to claim 8 or claim 9, **characterised in that** the magnetic type screening material is part of the group consisting of iron and steel.

13. Housing box according to any one of the preceding claims, **characterised in that** the additional conducting layer (20) has a thickness between 0.05 mm and 0.1 mm.

14. Housing box according to any one of the preceding claims, **characterised in that** it comprises a shell (10, 100) of plastic material or plastic matrix composite material, the conducting base layer (30) and the additional conducting layer (20) at least partially covering said shell (10, 100).

15. Housing box according to the preceding claim, **characterised in that** the shell (10, 100) having an inner side and an outer side with reference to a general shape of the box, the conducting base layer (30) and the additional conducting layer (20) are arranged on the same side of the shell (10, 100) amongst these two sides.

16. Housing box according to claim 14, **characterised in that** the shell (10, 100) having an inner side and an outer side with reference to a general shape of the box, the conducting base layer (30) and the additional conducting layer (20) are each arranged on a different side of the shell (10, 100) amongst these two sides.

17. Housing box according to any one of claims 14 to 16, **characterised in that** at least one of the layers amongst the conducting base layer (30) and the additional conducting layer (20) is made by providing a sheet of its component material(s) and placing this sheet over said shell (10, 100).

18. Use as a Housing box motor vehicle drive electric power transmission and/or storage on-board equipment of a box section describing a surface completely enclosing a housing for receiving equipment, the box section comprising a conducting base layer (30) made of at least one conducting material, extending entirely over the surface described by the box section, the box section further comprising an additional conducting layer (20) made of at least one conducting material different from the conducting material of the conducting base layer (30), at least partially covering said conducting base layer (30), the conducting base layer (30) and the additional conducting layer (20) being made by spraying their component materials, the conducting base layer (30) having a thickness between 0.05 mm and 0.5 mm.
